# EUROPÄISCHE PATENTSCHRIFT

(11) **EP 2 662 645 B1**
(45) Veröffentlichungstag und Bekanntmachung des Hinweises auf die Patenterteilung: **17.06.2020**
(21) Anmeldenummer: 13002179.3
(22) Anmeldetag: 25.04.2013
(51) Int. Cl.: F24S 25/35, H01L 31/042, H02S 20/23, F24S 25/61, F24S 25/636

(54) **Solarmodulhalter**
Solar module holder
Support de module solaire

(30) Priorität: 09.05.2012 DE 102012009486
(43) Veröffentlichungstag der Anmeldung: 13.11.2013
(73) Patentinhaber: K2 Systems GmbH, 71272 Renningen (DE)
(72) Erfinder: Kemmer, David, 70180 Stuttgart (DE); Wiggers, Melanie, 75446 Wiernsheim (DE); Seeg, Thomas, 73760 Ostfildern (DE)
(74) Vertreter: Clarenbach, Carl-Philipp

(56) Entgegenhaltungen:
- EP-A1- 2 239 783
- EP-A1- 2 410 190
- DE-A1-102009 008 683
- DE-A1-102011 052 129
- US-A1- 2011 179 606
- US-A1- 2011 260 027

## Beschreibung

Die Erfindung betrifft einen Solarmodulhalter zum klemmenden Halten eines Solarmoduls, der einen am Montageort befestigbaren Grundhalter, ein Zwischenelement und einen Klemmhalter aufweist, wobei eine Klemmfläche des Klemmhalters mit einer Gegenklemmfläche des Grundhalters eine Halteklemme für das Solarmodul bildet, und wobei das Zwischenelement quer zur Klemmrichtung der Halteklemme verschieblich an dem Grundhalter gehalten ist und der Klemmhalter mit dem Zwischenelement mittels einer eine Drehachse aufweisenden Schraubverbindung wirkverbunden ist.

Ein Solarmodulhalter der eingangs genannten Art ist beispielsweise aus der DE 10 2009 008 683 A1 bekannt und dient der Klemmbefestigung eines Solarmoduls auf einem Dach. Der Solarmodulhalter weist eine Schiene auf, die an dem Dach befestigt ist und in der ein Nutstein axial verschiebbar gelagert ist. Außerdem weist der Solarmodulhalter ein stufenförmig ausgebildetes Halteblech auf, das mit einer Öffnung versehen ist, sodass das Halteblech mittels einer Schraube an dem Nutstein befestigt werden kann. Bei der Montage des Solarmoduls wird das Solarmodul zunächst auf der Schiene positioniert und ausgerichtet. Anschließend wird der Nutstein mitsamt dem daran gehaltenen Halteblech derart verschoben und das Halteblech derart manuell ausgerichtet, dass das Halteblech einen Rahmen des Solarmoduls bereichsweise umgreift. Durch Anziehen der Schraube wird dann das Solarmodul klemmend zwischen der Schiene und dem Halteblech gehalten und ist somit sicher am Dach befestigt. Da sich der bekannte Solarmodulhalter aus mehreren Einzelteilen, insbesondere dem Nutstein, dem Halteblech und der Schraube zusammensetzt, kann die Montage je nach den Bedingungen auf dem Dach erschwert sein. Die Druckschrift EP 2 410 190 A1 betrifft eine Einrichtung zum Befestigen eines Gegenstandes an einem eine berandete Öffnung aufweisenden Bauteil. Die Einrichtung weist ein Klemmelement, ein Spreizelement und eine Schraube auf, wobei die Schraube eine Ausnehmung des Klemmelements durchgreift und in eine ein Innengewinde aufweisende Bohrung am Spreizelement einschraubbar ist.

Es ist daher Aufgabe der Erfindung, einen Solarmodulhalter zu schaffen, der sich durch eine einfache Konstruktion auszeichnet und gleichzeitig eine einfache und sichere Montage eines Solarmoduls ermöglicht.

Diese Aufgabe wird erfindungsgemäß mit den Merkmalen des Anspruchs 1 gelöst. Der Klemmhalter ist mittels einer Verdrehsicherung bezüglich der Drehachse der Schraubverbindung verdrehsicher am Zwischenelement geführt. Mittels der erfindungsgemäßen Verdrehsicherung wird somit einem Verdrehen des Klemmhalters gegenüber dem Zwischenelement entgegengewirkt, selbst dann, wenn die Schraubverbindung angezogen oder gelöst wird. Es wird also verhindert, dass sich beim Anziehen einer Schraube der Schraubverbindung der Klemmhalter gegenüber dem Zwischenelement verdreht. Dadurch ist sichergestellt, dass die relative Position des Klemmhalters und des Zwischenelements zueinander bezüglich der Drehachse sich bei der Montage des Solarmoduls am Montageort, insbesondere auf einem Dach, nicht verändert. Eine Person, die die Montage am Montageort vornimmt, muss insofern nicht darauf achten, dass der Klemmhalter und das Zwischenelement eine bestimmte relative Position zueinander annehmen, um das zu montierende Solarmodul klemmend zwischen der Klemmfläche des Klemmhalters und der Gegenklemmfläche des Grundhalters aufzu-nehmen. Vielmehr wird aufgrund der Verdrehsicherung dies automatisch sichergestellt, sodass die Person bei der Montage nicht darauf achten muss, da Fehlstellungen zwischen Klemmhalter und Zwischenelement vermieden sind. Die Führung des Klemmhalters am Zwischenelement wirkt auch in axialer Richtung, das heißt ent-lang der Drehachse. Somit ist ein Verschieben des Klemmhalters am Zwischenelement entlang der Drehachse möglich, jedoch ein Drehen des Klemmhalters um die Drehachse, wenn der Klemmhalter am Zwischenelement geführt ist, nicht möglich.

Erfindungsgemäß ist vorgesehen, dass das Zwischenelement mittels einer Nutsteinverbindung an dem Grundhalter gehalten ist. Die Nutsteinverbindung weist einen Nutstein sowie eine Aufnahme auf, wobei der Nutstein am Zwischenelement und die Aufnahme am Grundhalter vorgesehen sind und derart zusammenwirken, dass das Zwischenelement verschieblich durch Verschieben des Nutsteins in der Aufnahme am Grundhalter gehalten ist.

Nach einer Weiterbildung der Erfindung ist vorgesehen, dass der Klemmhalter mindestens eine Führungswand aufweist, die entlang eines Bereichs der Außenquerschnittskontur des Zwischenelements in Richtung der Drehachse verschieblich geführt ist. Die mindestens eine Führungswand lässt sich also in Richtung der Drehachse entlang des Bereichs der Außenquerschnittskontur des Zwischenelements bewegen. Eine Drehung des Klemmhalters um die Drehachse wird verhindert, da das Zwischenelement einen Anschlag für die Führungswand ausbildet und somit eine Drehung des Klemmhalters unterbindet.

Vorzugsweise ist vorgesehen, dass der Klemmhalter zwei parallel zueinander verlaufende Führungswände aufweist, zwischen denen ein Abschnitt des Zwischenelements führend aufgenommen ist. Der Klemmhalter umgreift insofern den Abschnitt des Zwischenelements. Wird nun versucht, den Klemmhalter, der auf dem Zwischenelement geführt ist, um die Drehachse zu drehen, so wirkt der Abschnitt jeweils als Anschlag für beide Führungswände.

Es ist vorteilhaft, wenn die Außenquerschnittskontur des Abschnitts des Zwischenelements und/oder einer Verlängerung des Abschnitts quadratisch ausgebildet ist. Aufgrund dieser Ausbildung lässt sich der Klemmhalter, insbesondere mit zwei parallel zueinander verlaufenden Führungswänden, in um 90° zueinander verdrehten Ausrichtungen auf dem Zwischenelement, insbesondere dem Abschnitt des Zwischenelements, führen. Aufgrund dieser symmetrischen Ausbildung des Abschnitts des Zwischenelements kann ein beispielsweise an einem insbesondere schrägen Dach befestigter Grundhalter sowohl dazu dienen, ein Solarmodul an einer seitlichen Seite klemmend zu halten als auch dazu dienen, ein Solarmodul an seiner Oberseite beziehungsweise Unterseite zu halten. Dadurch wird also ein vielseitiger Einsatz des Solarmodulhalters ermöglicht, der sich je nach den Montageortgegebenheiten und der gewünschten Anordnung des Solarmoduls/der Solarmodule ergibt. Entsprechendes gilt für die Verlängerung des Abschnitts, die mit dem Grundhalter zusammenwirkt.

Gemäß einer Weiterbildung der Erfindung ist vorgesehen, dass das Zwischenelement einen Längskanal aufweist, in den eine der Schraubverbindung angehörende Gewindeschraube eingreift. Zur Wirkverbindung des Klemmhalters mit dem Zwischenelement dient also die Gewindeschraube, die die Drehachse definiert.

Vorteilhafterweise ist vorgesehen, dass der Längskanal als Schraubkanal für die Gewindeschraube ausgebildet ist oder dass in den Längskanal eine Mutter für die Gewindeschraube eingesetzt ist. Der Schraubkanal bildet ein Innengewinde aus, in das die Gewindeschraube einschraubbar ist. Alternativ ist in den Längskanal eine Mutter beziehungsweise ein mutterähnliches Element eingesetzt, die/das eine Öffnung mit einem Innengewinde aufweist, in den die Gewindeschraube einschraubbar ist. Durch die Gewindeschraube und den Schraubkanal beziehungsweise die Mutter wird somit die genannte Schraubverbindung ausgebildet. Bei dem Längskanal handelt es sich vorzugsweise um einen Kanal im Zwischenelement, der von zumindest einer Seite des Zwischenelements, insbesondere zwei gegenüberliegenden Seiten des Zwischenelements, zugänglich ist, sodass das Einsetzen der Mutter ermöglicht wird. Unter dem "Schraubkanal" ist ein Kanal zu verstehen, an dessen vorzugsweise ebenen Kanalwänden Gewindekonturen ausgebildet sind, die mit dem Gewinde der Gewindeschraube zusammenwirken.

In einer bevorzugten Weiterbildung der Erfindung ist vorgesehen, dass im Längskanal mindestens ein Stützvorsprung zur axialen Festlegung der Mutter vorgesehen ist. Vorzugsweise sind zwei an gegenüberliegenden Innenseiten des Zwischenelements vorgesehene Stützvorsprünge im Längskanal ausgebildet. Durch den mindestens einen Stützvorsprung wird die Mutter axial unverschieblich beziehungsweise axial begrenzt verschieblich in dem Längskanal festgelegt.

Vorzugsweise ist vorgesehen, dass die Mutter verdrehsicher im Längskanal aufgenommen ist. Die Außenquerschnittskontur der Mutter und die Innenquerschnittskontur des Längskanals sind demnach derart aufeinander abgestimmt, dass ein Drehen der Mutter um die Drehachse verhindert wird. Dabei bildet vorzugsweise mindestens eine Innenseite des Längskanals einen Anschlag für die Mutter. Vorteilhafterweise wird durch diese Ausbildung sichergestellt, dass sich bei der Montage eines Solarmoduls beim Anziehen der Gewindeschraube die Mutter nicht mitdreht. Dadurch vereinfacht sich die Montage des Solarmoduls an dem Montageort, insbesondere einem Dach, erheblich.

Bevorzugt ist vorgesehen, dass die Führungswände des Klemmhalters mittels eines Querstegs miteinander verbunden sind. Der Quersteg verbindet vorzugsweise die zwei parallel zueinander verlaufenden Führungswände des Klemmhalters, sodass insgesamt eine H-förmige Längsschnittform des Klemmhalters realisiert wird.

Insbesondere ist vorgesehen, dass die Gewindeschraube eine Öffnung des Querstegs durchgreift und sich mit einem Schraubenkopf am Quersteg zum Aufbringen einer Klemmkraft der Halteklemme abstützt. Die Öffnung des Querstegs fluchtet mit dem Längskanal des Zwischenelements, sodass der die Öffnung des Querstegs durchgreifende Gewindeschaft der Gewindeschraube in den Schraubkanal beziehungsweise die im Längskanal angeordnete Mutter eingeschraubt werden kann und sich dabei der Schraubenkopf der Gewindeschraube an dem Quersteg abstützt. Durch das Anziehen der Gewindeschraube wird der Klemmhalter entlang der Drehachse auf dem Zwischenelement geführt/verlagert, wodurch der Abstand zwischen der Klemmfläche des Klemmhalters und der Gegenklemmfläche des am Montageort fest angeordneten/anordbaren Grundhalters verkleinert wird. Dadurch wird die genannte Klemmkraft auf das Solarmodul, das zwischen der Klemmfläche und der Gegenklemmfläche angeordnet ist, ausgeübt und das Solarmodul insgesamt klemmend zwischen dem Klemmhalter und dem Grundhalter gehalten.

Insbesondere ist vorgesehen, dass das Zwischenelement den Nutstein aufweist, der in der Aufnahme des Grundhalters eingeschoben ist und der sich beim Aufbringen der Klemmkraft der Halteklemme unverschieblich an einer Aufnahmefläche der Aufnahme des Grundhalters abstützt. Durch einfaches Einschieben des Nutsteins des Zwischenelements in die Aufnahme des Grundhalters wird daher das Zwischenelement am Grundhalter lösbar und verschieblich gehalten. Wird eine Klemmkraft aufgebracht, das heißt die Gewindeschraube angezogen, also in den Schraubkanal beziehungsweise die Mutter eingeschraubt, so wird der Nutstein gegen eine die Aufnahme begrenzende Aufnahmefläche gedrängt und stützt sich somit an dieser Aufnahmefläche ab, sodass insgesamt der Nutstein unverschieblich in der Aufnahme verklemmt ist. Mit anderen Worten: Das Zwischenelement verkeilt sich an dem Grundhalter, sodass das Zwischenelement und der Grundhalter unbeweglich zueinander angeordnet sind. Somit wird durch die Schraubverbindung sowohl die auf das Solarmodul wirkende Klemmkraft, mittels welcher mindestens ein Solarmodul an dem Solarmodulhalter gehalten wird, erzeugt als auch das Zwischenelement des Solarmodulhalters relativ zum Grundhalter des Solarmodulhalters festgelegt, sodass das Solarmodul ortsfest an dem Montageort, insbesondere dem Dach, befestigt ist. Vorteilhafterweise ist aufgrund dieser Ausbildung keine zusätzliche Maßnahme erforderlich, mittels welcher die verschiebliche Verbindung des Zwischenelements am Grundhalter fixiert wird.

Bevorzugt ist vorgesehen, dass der Grundhalter eine Grundplatte aufweist, an der zwei parallel zueinander verlaufende, sich quer zur Ebene der Grundplatte erstreckende Wände vorgesehen sind, zwischen denen die Aufnahme mittels eines an zumindest einer der Wände ausgebildeten Längsvorsprungs ausgebildet ist. Die Grundplatte des Grundhalters wird vorzugsweise an dem Montageort, insbesondere dem Dach, befestigt. Die zwei parallel verlaufenden Wände erstrecken sich vorzugsweise unter einem rechten Winkel zur Grundplatte. Die Aufnahme wird durch einen Bereich der Grundplatte, jeweils einen Bereich der Wände und dem mindestens einen Längsvorsprung, der an mindestens einer der zwei Wände ausgebildet ist, begrenzt. Vorzugsweise ist an beiden Wänden jeweils ein Längsvorsprung ausgebildet, wobei die Längsvorsprünge sich einander gegenüberliegen. Aufgrund dieser Ausbildung weist die Aufnahme im Längsschnitt ein C-Profil auf. Insgesamt ist der Grundhalter vorzugsweise symmetrisch und schienenartig ausgebildet. Vorzugsweise bildet der mindestens eine Längsvorsprung die voranstehend genannte Aufnahmefläche, gegen die sich der Nutstein des Zwischenelements abstützt, wenn eine Klemmkraft an der Halteklemme aufgebracht wird.

Vorzugsweise ist vorgesehen, wenn sich die Verlängerung des Abschnitts des Zwischenelements führend bis zwischen die Wände des Grundhalters in Richtung auf den Längsvorsprung erstreckt. Der vorzugsweise eine quadratische Außenquerschnittskontur aufweisende Abschnitt des Zwischenelements ragt mit seiner Verlängerung insofern zwischen die zwei Wände des Grundhalters. Bei einem Verschieben des Zwischenelements in Bezug auf den Grundhalter wirken die Wände des Grundhalters demnach als Führung für die Verlängerung des Abschnitts des Zwischenelements. Dadurch wird vorteilhafterweise die mechanische Belastbarkeit des Solarmodulhalters erhöht und ein Verkeilen des Zwischenelements bei einem Verschieben von diesem vermieden.

Bei einer Weiterbildung der Erfindung ist vorgesehen, dass der Nutstein über einen einen Hals des Zwischenelements bildenden Haltesteg mit der Verlängerung des Abschnitts verbunden ist, wobei der Längsvorsprung an den Hals grenzt. Der Hals des Zwischenelements weist insofern einen kleineren Querschnitt auf als die Verlängerung und der Nutstein des Zwischenelements. Insbesondere weisen der Abschnitt, die Verlängerung und der Nutstein eine identische Außenquerschnittskontur, insbesondere eine quadratische Außenquerschnittskontur, auf. Der mindestens eine Längsvorsprung des Grundhalters grenzt an den Hals des Zwischenelements, wodurch eine Führung realisiert ist. Mit anderen Worten: Der an der mindestens einen Wand des Grundhalters vorgesehene Längsvorsprung greift in eine Aufnahmenut des Zwischenelements ein, die durch die Verlängerung, den Hals und den Nutstein des Zwischenelements ausgebildet wird.

Bei einer Weiterbildung der Erfindung ist vorgesehen, dass von der Führungswand des Zwischenelements ein die Klemmfläche aufweisender Klemmsteg wegragt und dass von mindestens einer der Wände des Grundhalters ein die Gegenklemmfläche aufweisender Gegenklemmsteg wegragt. Der Gegenklemmsteg erstreckt sich vorzugsweise über die gesamte Längserstreckung des Grundhalters. Der Gegenklemmsteg dient zur Auflage eines Randbereichs, insbesondere eines Rahmens, des Solarmoduls. Durch Festziehen der Schraubverbindung wird der Klemmsteg mit seiner Klemmfläche an einen von dem Montageort, insbesondere dem Dach, wegweisenden Bereich, insbesondere des Rahmens, des Solarmoduls gepresst, sodass das Solarmodul zwischen dem Klemmsteg und dem Gegenklemmsteg klemmend und dadurch sicher gehalten ist. Vorzugsweise verlaufen der Klemmsteg und der Gegenklemmsteg im Wesentlichen parallel. Bevorzugt ragt von beiden Wänden des Grundhalters jeweils ein Gegenklemmsteg weg. Insbesondere schließen der Gegenklemmsteg und die jeweilige Wand jeweils einen rechten Winkel miteinander ein. Außerdem weist das Zwischenelement vorzugsweise jeweils zwei Führungswände mit jeweils einem Klemmsteg auf, sodass insgesamt der Klemmhalter und der Grundhalter symmetrisch ausgebildet sind und mittels eines derartigen Solarmodulhalters zwei vertikal oder horizontal zueinander benachbarte Solarmodule gehalten werden können.

Ferner ist es vorteilhaft, wenn das Zwischenelement, der Klemmhalter und/oder der Grundhalter als ein Strangpressbauteil/Strangpressbauteile ausgebildet ist/sind. Vorzugsweise wird das Innengewinde des Schraubkanals beim Strangpressen miterzeugt. Unter dem Innengewinde ist dabei eine Zahnung an der Innenseite des Längskanals zu verstehen, wobei der Längskanal aufgrund des Strangpressens und des danach erfolgenden Schneideprozesses zum Separieren einzelner Zwischenelemente ein offener Kanal ist, der zu zwei gegenüberliegenden Seiten offen ausgebildet ist. Das durch den Schraubkanal ausgebildete Innengewinde umgibt insofern die darin eingreifende Schraube nicht in Umfangsrichtung, sondern tangiert diese lediglich an zwei Seiten. Das Strangpressen ermöglicht einen einfachen und kostengünstigen Herstellprozess der genannten Bauteile.

Die Zeichnungen veranschaulichen die Erfindung anhand von Ausführungsbeispielen, und zwar zeigt:
- Figur 1: ein auf einem Dach mittels Solarmodulhaltern befestigtes Solarmodul,
- Figur 2: eine Schnittansicht des Solarmodulhalters gemäß einem ersten Ausführungsbeispiel,
- Figur 3: eine Explosionsdarstellung des Solarmodulhalters gemäß Figur 2,
- Figur 4: eine Schnittansicht des Solarmodulhalters gemäß einem zweiten Ausführungsbeispiel,
- Figur 5: eine Explosionsdarstellung des Solarmodulhalters gemäß Figur 4,
- Figur 6: eine perspektivische Darstellung des Solarmodulhalters in einer ersten Stellung und
- Figur 7: eine perspektivische Darstellung des Solarmodulhalters der Figur 6 in einer zweiten Stellung.

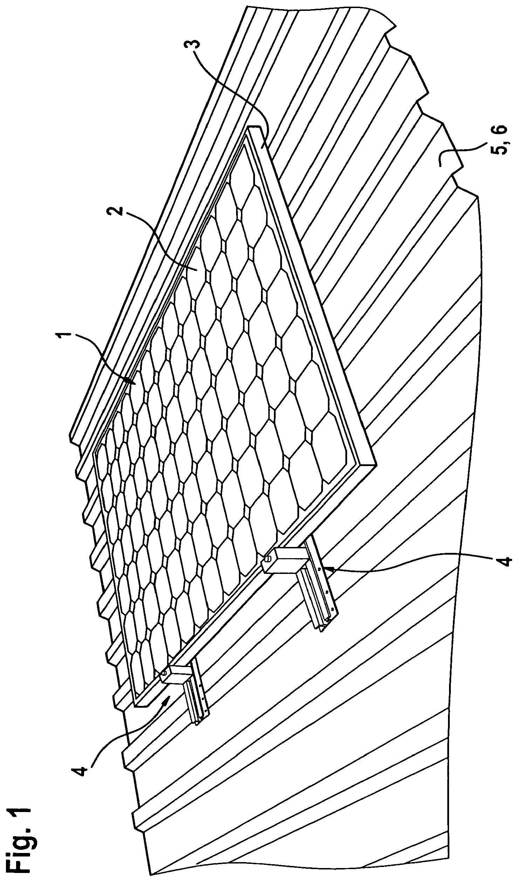

Die Figur 1 zeigt ein Solarmodul 1, das Solarzellen 2 und einen die Solarzellen 2 umgebenden Rahmen 3 aufweist. Das Solarmodul 1 ist mittels zwei Solarmodulhaltern 4 an einem Dach 5, insbesondere einem Trapezblechdach 6, befestigt. Die Solarmodulhalter 4 sind in Figur 1 nur schematisch angedeutet. Im Folgenden soll im Detail auf die Solarmodulhalter 4 eingegangen werden.

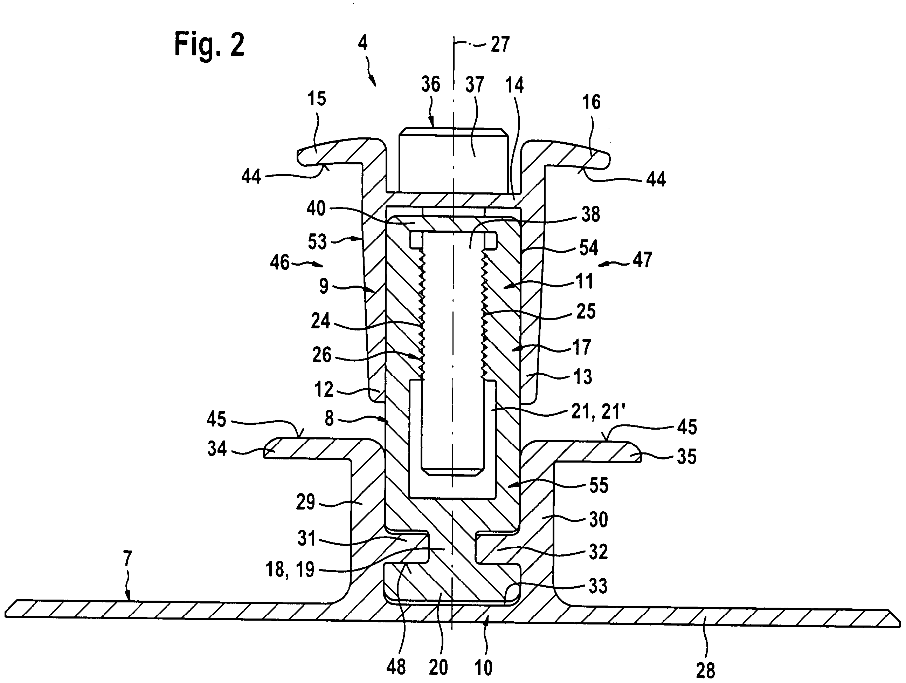

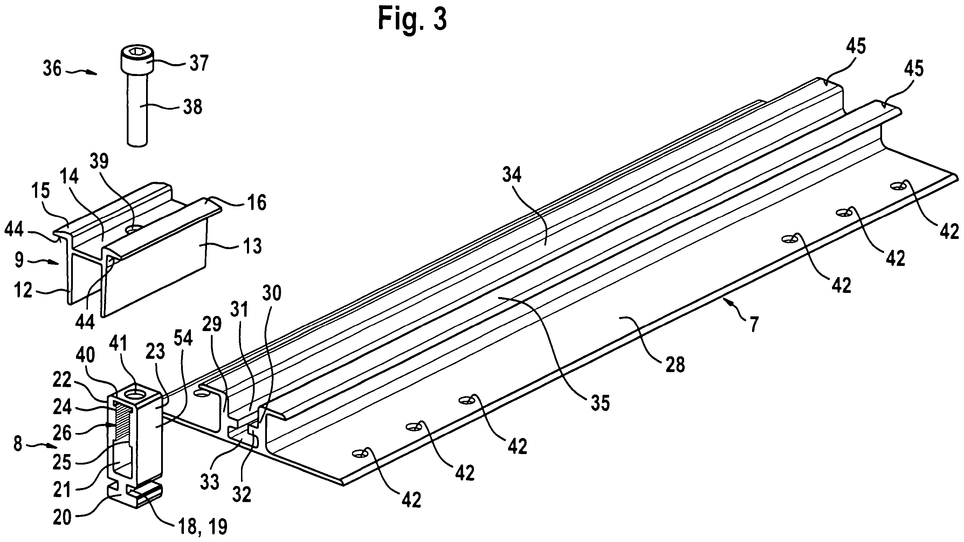

Die Figuren 2 und 3 zeigen einen Solarmodulhalter 4 gemäß einem ersten Ausführungsbeispiel, wobei die Figur 2 eine Längsschnittdarstellung und die Figur 3 eine Explosionsdarstellung des Solarmodulhalters 4 ist. Der Solarmodulhalter 4 weist einen Grundhalter 7, ein Zwischenelement 8 und einen Klemmhalter 9 auf. Der Grundhalter 7, das Zwischenelement 8 und der Klemmhalter 9 sind vorzugsweise jeweils als Strangpressbauteil ausgebildet. Das Zwischenelement 8 ist mit dem Grundhalter 7 mittels einer Nutsteinverbindung 10 verbunden. Der Klemmhalter 9 ist am Zwischenelement 8 geführt und mittels einer Schraubverbindung 11 mit dem Zwischenelement 8 wirkverbunden.

Der Klemmhalter 9 weist zwei parallel zueinander verlaufende Führungswände 12, 13 auf, die mittels eines Querstegs 14 miteinander verbunden sind. Die Führungswände 12, 13 und der Quersteg 14 bilden im Längsschnitt des Solarmodulhalters 4 gemäß Figur 2 eine H-Form aus. Der Klemmhalter 9 weist außerdem zwei Klemmstege 15, 16 auf, die von jeweils einer der Führungswände 12, 13 in entgegengesetzte Richtungen wegragen. Dabei schließen sie etwa einen 90°-Winkel mit der jeweiligen Führungswand 12, 13 ein. Die Klemmstege 15, 16 dienen dazu, den Rahmen 3 des Solarmoduls 1 bei der Montage des Solarmoduls 1 auf dem Dach 5 zu umgreifen und um somit eine auf den Rahmen 3 in Richtung des Daches 5 wirkende Klemmkraft zu erzeugen.

Das Zwischenelement 8 des Solarmodulhalters 4 weist einen eine quadratische Außenquerschnittskontur 54 aufweisenden Abschnitt 17, eine sich an den Abschnitt 17 anschließende Verlängerung 55, einen daran anschließenden einen Hals 18 ausbildenden Haltesteg 19 und einen an den Haltesteg 19 anschließenden Nutstein 20 auf. Der Nutstein 20 weist die gleiche quadratische Außenquerschnittskontur 54 wie der Abschnitt 17 und die Verlängerung 55 auf. In dem Abschnitt 17 und der Verlängerung 55 des Zwischenelements 8 ist ein Längskanal 21 ausgebildet. Da es sich bei dem Zwischenelement 8 um ein Strangpressbauteil handelt, sind zwei Seiten der quadratischen Außenquerschnittskontur 54 des Abschnitts 17 und der Verlängerung 55 offen ausgebildet und der Längskanal 21 weist im Längsschnitt gemäß Figur 2 im Wesentlichen eine Rechteckform auf. Der Längskanal 21 ist als Schraubkanal 21' ausgebildet, das heißt, er weist an seinen parallel zueinander verlaufenden Zwischenelementwänden 22, 23 innen jeweils eine Zahnung 24, 25 auf, wobei die Zahnungen 24, 25 ein Innengewinde 26 der eine Drehachse 27 definierenden Schraubverbindung 11 ausbilden.

Der Grundhalter 7 des Solarmodulhalters 4 weist eine Grundplatte 28 auf. An der Grundplatte 28 sind zwei parallel verlaufende, sich unter einem rechten Winkel von der Grundplatte 28 weg erstreckende Wände 29, 30 vorgesehen. Der Abstand zwischen den Wänden 29, 30 entspricht etwa oder ist etwas größer als eine Seite der quadratischen Außenquerschnittsform 54 des Abschnitts 17 beziehungsweise der Verlängerung 55 beziehungsweise des Nutsteins 20 des Zwischenelements 8. An den Wänden 29, 30 des Grundhalters 7 ist an deren einander gegenüberliegenden Seiten jeweils ein Längsvorsprung 31, 32 ausgebildet. Die Längsvorsprünge 31, 32, jeweils ein Bereich der Wände 29, 30 und ein Bereich der Grundplatte 28 definieren eine Aufnahme 33 des Grundhalters 7, in die der Nutstein 20 des Zwischenelements 8 einschiebbar ist. Die Aufnahme 33 ist als C-förmige Aufnahme 33 ausgebildet. An jeder der Wände 29, 30 ist ferner jeweils ein Gegenklemmsteg 34, 35 vorgesehen. Die Gegenklemmstege 34, 35 ragen von der jeweiligen Wand 29, 30 unter einem rechten Winkel in entgegengesetzte Richtungen weg.

Der Solarmodulhalter 4 weist ferner eine Gewindeschraube 36 auf, die die Schraubverbindung 11 mit ausbildet. Die Gewindeschraube 36 weist einen Schraubenkopf 37 und einen mit einem Gewinde versehenen Schaft 38 auf. Im montierten Zustand des Solarmodulhalters 4 (Figur 2) durchgreift der Schaft 38 eine im Quersteg 14 des Klemmhalters 9 vorgesehene Öffnung 39 sowie eine in einer Stirnseite 40 des Zwischenelements 8 vorgesehene Öffnung 41, die Zutritt zu dem Schraubkanal 21' des Zwischenelements 8 bietet. Das Gewinde des Schafts 38 lässt sich in das durch den Schraubkanal 21' ausgebildete Innengewinde 26 einschrauben. Die Öffnung 41 in der Stirnseite 40 des Zwischenelements 8 weist nur einen geringfügig größeren Durchmesser als der Schaft 38 der Gewindeschraube 36 auf, sodass die Gewindeschraube 37 dort geführt wird.

In der Grundplatte 28 des Grundhalters 7 sind jeweils an beiden Seiten von den Wänden 29, 30 mehrere Durchgangslöcher 42 mit Abstand zueinander vorgesehen, die dazu dienen, den Grundhalter 7 zum Beispiel an dem Dach 5 mittels nicht dargestellten Schrauben zu befestigen. Der Grundhalter 7 weist vorzugsweise eine Länge von 350 bis 450 mm, insbesondere von etwa 400 mm, auf. Der Grundhalter 7 ist somit mit diesem Lochbild auf jedem Trapezblechdach mit einem Sickenabstand von bis zu 375 mm befestigbar.

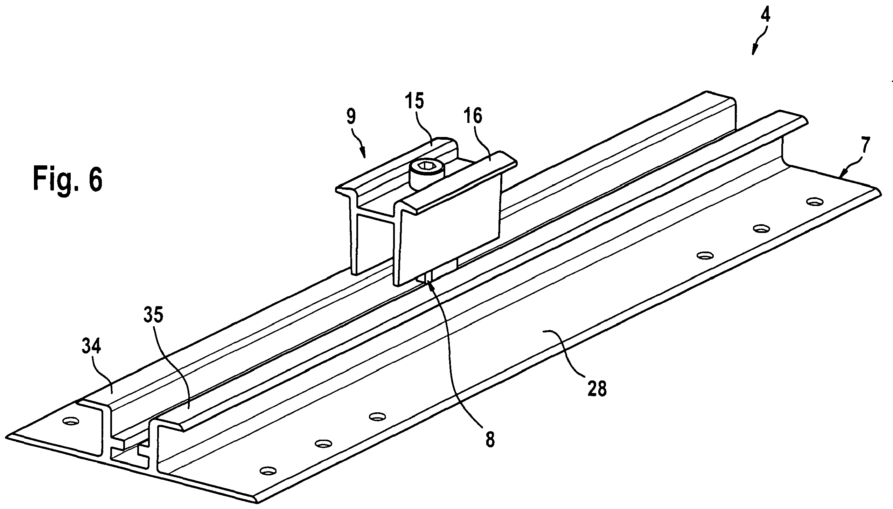

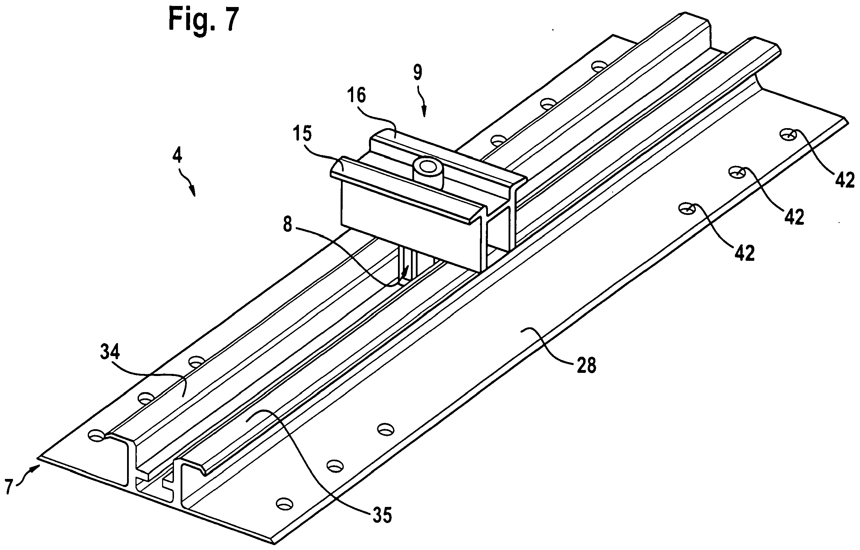

Es ergibt sich folgende Funktion des Solarmodulhalters 4: Zur Befestigung des Solarmoduls 1 auf dem Dach 5, insbesondere dem Trapezblechdach 6, wird der Grundhalter 7 an dem Dach 5 befestigt. Dann wird eine vormontierte Einheit aus Zwischenelement 8 und Klemmhalter 9 mit dem Nutstein 20 des Zwischenelements 8 in die Aufnahme 33 des Grundhalters 7 eingeschoben. Der Klemmhalter 9 ist mit seinen Führungswänden 12, 13 auf den im Querschnitt quadratischen Abschnitt 17 des Zwischenelements 8 geschoben und daher mittels einer so gebildeten Verdrehsicherung 53 drehausgerichtet gehalten. Aufgrund der quadratischen Ausbildung des Abschnitts 17 des Zwischenelements 8 und den parallel verlaufenden Führungswänden 12, 13 des Klemmhalters 9 kann der Klemmhalter 9 in genau zwei unterschiedlichen Stellungen - die in Figur 6 und 7 dargestellt sind und die sich um 90° unterscheiden - auf das Zwischenelement 8 aufgebracht sein. Zusätzlich oder alternativ ist es möglich, dass der Nutstein 20 in zwei um 90° unterschiedlichen Stellungen (Figuren 6 und 7) in die Aufnahme 33 eingeschoben wird. Die vormontierte Gewindeschraube 36 ist mit ihrem Schaft 38 durch die Öffnungen 39 und 41 geführt und bereichsweise in das Innengewinde 26 des Schraubkanals 21' eingeschraubt. Natürlich kann der Solarmodulhalter 4 auch während der Montage auf dem Dach 5 durch Zusammensetzen seiner Einzelteile aufgebaut werden; dies ist jedoch am Montageort oftmals schwierig. Im nächsten Schritt wird das Solarmodul 1, insbesondere mit seinem Rahmen 3, auf einem der Gegenklemmstege 34, 35 des Grundhalters 7 wie gewünscht positioniert. Danach wird das Zwischenelement 8 mit dem lose an diesem befestigten Klemmhalter 9 derart entlang des Grundhalters 7 verschoben, bis der eine Klemmsteg 15, 16 des Klemmhalters 9 das Solarmodul 1 beziehungsweise dessen Rahmen 3 bereichsweise übergreift. Es wird nun die Gewindeschraube 36 weiter in das Innengewinde 26 des Schraubkanals 21' eingeschraubt. Dabei wird durch den Abschnitt 17 des Zwischenelements 8 und die beiden Führungswände 12, 13 des Klemmhalters 9 die Verdrehsicherung 53 ausgebildet, die eine Vorausrichtung der Teile sicherstellt und verhindert, dass durch das Anziehen der Gewindeschraube 6 der Klemmhalter 9 mitgedreht wird. Somit ist es nicht erforderlich, dass eine Person den Klemmhalter 9 beim Anziehen der Gewindeschraube 36 manuell fixieren muss. Durch das Anziehen der Gewindeschraube 36 wird der Klemmsteg 15, 16 auf das Solarmodul 1 beziehungsweise dessen Rahmen 3 gepresst und somit eine auf das Solarmodul 1 wirkende Klemmkraft erzeugt, mittels der das Solarmodul 1 sicher zwischen dem Grundhalter 7 und dem Klemmhalter 9 gehalten wird. Der Klemmsteg 15, 16 weist dafür eine von oben auf das Solarmodul 1 aufliegende Klemmfläche 44 auf und der Gegenklemmsteg 34, 35 besitzt eine von unten an das Solarmodul 1 anliegende Gegenklemmfläche 45. Die Klemmfläche 44 und die Gegenklemmfläche 45 des jeweiligen Klemmstegs 15, 16 beziehungsweise Gegenklemmstegs 34, 35 bilden somit jeweils eine Halteklemme 46 aus. Die Klemmkraft wirkt auf das Solarmodul 1 in Richtung der Drehachse 27. Durch das Anziehen der Gewindeschraube 36 und die dadurch erzeugte auf das Solarmodul 1 wirkende Klemmkraft wird gleichzeitig der Nutstein 20 gegen die eine Aufnahmefläche 48 aufweisenden Längsvorsprünge 31, 32 gepresst, das heißt in Richtung der Drehachse 27, wodurch eine Verschiebung des Nutsteins 20 in der Aufnahme 33, insbesondere rechtwinklig zur Drehachse 27, unterbunden wird und somit der Nutstein 20 und daher das Zwischenelement 8 in der Aufnahme 33 am Grundhalter 7 unverschieblich fixiert ist.

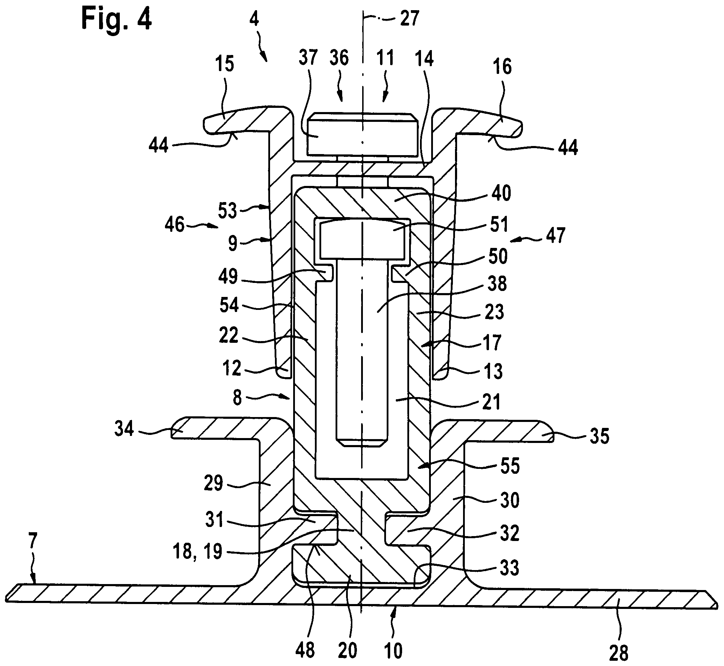

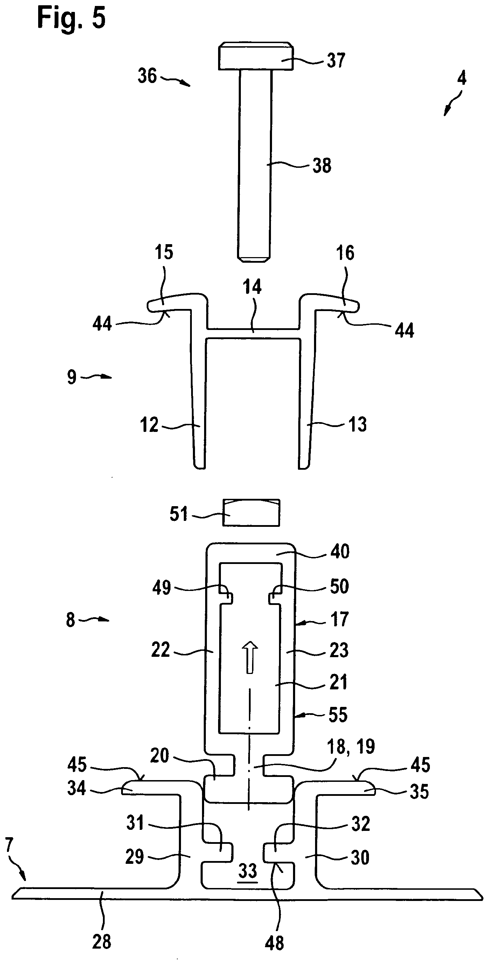

Die Figuren 4 und 5 zeigen einen Solarmodulhalter 4 gemäß einem zweiten Ausführungsbeispiel, wobei die Figur 4 eine Schnittdarstellung und die Figur 5 eine Explosionsdarstellung ist. Der Solarmodulhalter 4 gemäß dem zweiten Ausführungsbeispiel entspricht zum größten Teil dem Solarmodulhalter 4 gemäß dem ersten Ausführungsbeispiel (Figuren 2 und 3), sodass insofern auf die Figurenbeschreibung zu den Figuren 2 und 3 verwiesen wird und lediglich auf die Unterschiede eingegangen wird.

Das Zwischenelement 8 des Solarmodulhalters 4 gemäß dem zweiten Ausführungsbeispiel weist ebenfalls einen Längskanal 21 auf. Der Längskanal 21 wird von zwei Seiten von den Zwischenelementwänden 22, 23, die einander gegenüberliegen begrenzt und ist von den anderen beiden Seiten zugänglich. An den Zwischenelementwänden 22, 23 ist jeweils ein Stützvorsprung 49, 50 ausgebildet. Die Stützvorsprünge 49, 50 liegen einander gegenüber und ragen in den Längskanal 21 hinein. In den Längskanal 21 ist eine Mutter 51 eingesetzt, die auf den Stützvorsprüngen 49, 50 aufliegt und an die Stirnseite 40 angrenzt. Die Mutter 51 weist eine Durchgangsöffnung mit einem Innengewinde auf. Die Mutter 51 ist insofern axial im Wesentlichen unverschieblich in dem Längskanal 21 angeordnet und zwischen den Zwischenelementwänden 22, 23 verdrehsicher gehalten. Wird bei der Montage die Gewindeschraube 36 weiter in das Innengewinde der Mutter 51 eingeschraubt, so wird die Klemmfläche 44 gegen das sich an der Gegenklemmfläche 45 abstützende Solarmodul 1 gepresst und dadurch eine Klemmkraft erzeugt.

Die Figuren 6 und 7 zeigen - wie bereits erwähnt - zwei mögliche Anordnungen des Klemmhalters 9 auf dem Zwischenelement 8 und/oder des Nutsteins 20 in der Aufnahme 33. Bei dem Zwischenelement 8 kann es sich um ein Zwischenelement 8 gemäß dem ersten Ausführungsbeispiel mit einem Schraubkanal 21' oder um ein Zwischenelement 8 gemäß dem zweiten Ausführungsbeispiel mit einer Mutter 51 handeln. Aufgrund der symmetrischen Ausbildung des Zwischenelements 8 und des Klemmhalters 9 mit den zwei parallel zueinander verlaufenden Klemmstegen 15, 16 gibt es genau zwei unterschiedliche Anordnungsmöglichkeiten des Zwischenklemmhalters 9 auf dem Zwischenelement 8. Diese sind um 90° zueinander verdreht. Entsprechendes gilt für die Zuordnung des Nutsteins 20 in der Aufnahme 33. Somit kann der Solarmodulhalter 4 dazu dienen, das Solarmodul 1 an einer seiner seitlichen Seiten oder an seinem oberen oder unteren Rand klemmend zu halten.

Da der Solarmodulhalter 4 symmetrisch ausgebildet ist, können mittels eines Solarmodulhalters 4 zwei Solarmodule 1, die benachbart zueinander auf dem Dach angeordnet werden sollen, gehalten werden. Natürlich ist es auch möglich, nur einen der Klemmstege 15, 16 und Gegenklemmstege 34, 35 zum Halten von nur einem Solarmodul 1 zu nutzen, das beispielsweise am Rand eines Solarmodularrays angeordnet ist.

## Patentansprüche

1. Solarmodulhalter (4) zum klemmenden Halten eines Solarmoduls (1), der einen am Montageort befestigbaren Grundhalter (7), ein Zwischenelement (8) und einen Klemmhalter (9) aufweist, wobei eine Klemmfläche (44) des Klemmhalters (9) mit einer Gegenklemmfläche (45) des Grundhalters (7) eine Halteklemme (46,47) für das Solarmodul (1) bildet, und wobei das Zwischenelement (8) quer zur Klemmrichtung der Halteklemme (46,47) verschieblich an dem Grundhalter (7) gehalten ist und der Klemmhalter (9) mit dem Zwischenelement (8) mittels einer eine Drehachse (27) aufweisenden Schraubverbindung (11) wirkverbunden ist, wobei der Klemmhalter (9) mittels einer Verdrehsicherung (53) bezüglich der Drehachse (27) der Schraubverbindung (11) verdrehsicher am Zwischenelement (8) geführt ist, **dadurch gekennzeichnet, dass** das Zwischenelement (8) mittels einer Nutsteinverbindung (10) an dem Grundhalter (7) gehalten ist.

2. Solarmodulhalter nach Anspruch 1, **dadurch gekennzeichnet, dass** der Klemmhalter (9) mindestens eine Führungswand (12,13) aufweist, die entlang eines Bereichs der Außenquerschnittskontur (54) des Zwischenelements (8) in Richtung der Drehachse (27) verschieblich geführt ist.

3. Solarmodulhalter nach einem der vorhergehenden Ansprüche, **dadurch gekennzeichnet, dass** der Klemmhalter (9) zwei parallel zueinander verlaufende Führungswände (12,13) aufweist, zwischen denen ein Abschnitt (17) des Zwischenelements (8) führend aufgenommen ist.

4. Solarmodulhalter nach Anspruch 3 in Verbindung mit Anspruch 2, **dadurch gekennzeichnet, dass** die Außenquerschnittskontur (54) des Abschnitts (17) des Zwischenelements (8) und/oder einer Verlängerung (55) des Abschnitts (17) quadratisch ausgebildet ist.

5. Solarmodulhalter nach einem der vorhergehenden Ansprüche, **dadurch gekennzeichnet, dass** das Zwischenelement (8) einen Längskanal (21) aufweist, in den eine der Schraubverbindung (11) angehörende Gewindeschraube (36) eingreift.

6. Solarmodulhalter nach Anspruch 5, **dadurch gekennzeichnet, dass** der Längskanal (21) als Schraubkanal (21') für die Gewindeschraube (36) ausbildet ist oder dass in den Längskanal (21) eine Mutter (51) für die Gewindeschraube (36) eingesetzt ist.

7. Solarmodulhalter nach Anspruch 6, **dadurch gekennzeichnet, dass** im Längskanal (21) mindestens ein Stützvorsprung (49,50) zur axialen Festlegung der Mutter (51) vorgesehen ist.

8. Solarmodulhalter nach einem der Ansprüche 6 oder 7, **dadurch gekennzeichnet, dass** die Mutter (51) verdrehsicher im Längskanal (21) aufgenommen ist.

9. Solarmodulhalter nach Anspruch 3, **dadurch gekennzeichnet, dass** die Führungswände (12,13) des Klemmhalters (9) mittels eines Querstegs (14) miteinander verbunden sind.

10. Solarmodulhalter nach Anspruch 9 in Verbindung mit Anspruch 5, **dadurch gekennzeichnet, dass** die Gewindeschraube (36) eine Öffnung (39) des Querstegs (14) durchgreift und sich mit einem Schraubenkopf (37) am Quersteg (14) zum Aufbringen einer Klemmkraft der Halteklemme (46,47) abstützt.

11. Solarmodulhalter nach einem der vorhergehenden Ansprüche, **dadurch gekennzeichnet, dass** das Zwischenelement (8) einen Nutstein (20) aufweist, der in eine Aufnahme (33) des Grundhalters (7) eingeschoben ist und der sich beim Aufbringen der Klemmkraft der Halteklemme (46,47) unverschieblich an einer Aufnahmefläche (48) der Aufnahme (33) des Grundhalters (7) abstützt.

12. Solarmodulhalter nach Anspruch 11, **dadurch gekennzeichnet, dass** der Grundhalter (7) eine Grundplatte (28) aufweist, an der zwei parallel zueinander verlaufende, sich quer zur Ebene der Grundplatte (28) erstreckende Wände (29,30) vorgesehen sind, zwischen denen die Aufnahme (33) mittels eines an zumindest einer der Wände (29,30) ausgebildeten Längsvorsprungs (31,32) ausgebildet ist.

13. Solarmodulhalter nach Anspruch 12 in Verbindung mit Anspruch 4, **dadurch gekennzeichnet, dass** sich die Verlängerung (55) des Abschnitts (17) des Zwischenelements (8) führend bis zwischen die Wände (29,30) des Grundhalters (7) in Richtung auf den Längsvorsprung (31,32) erstreckt.

14. Solarmodulhalter nach Anspruch 12 in Verbindung mit Anspruch 4, **dadurch gekennzeichnet, dass** der Nutstein (20) über einen einen Hals (18) des Zwischenelements (8) bildenden Haltesteg (19) mit der Verlängerung (55) verbunden ist, wobei der Längsvorsprung (31,32) an den Hals (18) grenzt.

15. Solarmodulhalter nach den Ansprüchen 2 und 12 oder 3 und 12, **dadurch gekennzeichnet, dass** von der mindestens einen Führungswand (12,13) des Klemmhalters (9) ein die Klemmfläche (44) aufweisender Klemmsteg (15,16) wegragt und dass von mindestens einer der Wände (29,30) des Grundhalters (7) ein die Gegenklemmfläche (45) aufweisender Gegenklemmsteg (34,35) wegragt.

16. Solarmodulhalter nach einem der vorhergehenden Ansprüche, **dadurch gekennzeichnet, dass** das Zwischenelement (8), der Klemmhalter (9) und/oder der Grundhalter (7) als ein Strangpressbauteil/Strangpressbauteile ausgebildet ist/sind.

17. Solarmodulhalter nach zumindest einem der vorhergehenden Ansprüche 11 und/oder 14, **dadurch gekennzeichnet, dass** der Hals (18) und/oder der Nutstein (20) eine quadratische Umfangskontur aufweist/aufweisen.

## Claims

1. Solar module holder (4) for clampingly holding a solar module (1), which has a basic holder (7) which can be fastened at the mounting location, an intermediate element (8) and a clamping holder (9), wherein a clamping surface (44) of the clamping holder (9) forms a holding clamp (46, 47) for the solar module (1) with a counterclamping surface (45) of the basic holder (7), and wherein the intermediate element (8) is held on the basic holder (7) displaceably transversely to the clamping direction and the clamping holder (9) is operatively connected to the intermediate element (8) by means of a screw connection (11) having an axis of rotation (27), the clamping holder (9) being guided on the intermediate element (8) in a non-rotatable manner with respect to the axis of rotation (27) of the screw connection (11) by means of a rotation lock (53), **characterised in that** the intermediate element (8) is held on the basic holder (7) by means of a slot nut connection (10).

2. Solar module holder according to claim 1, **characterised in that** the clamping holder (9) has at least one guide wall (12, 13) which is guided displaceably along a region of the outer cross-sectional contour (54) of the intermediate element (8) in the direction of the axis of rotation (27).

3. Solar module holder according to any of the preceding claims, **characterised in that** the clamping holder (9) has two guide walls (12, 13) which run parallel to one another and between which a section (17) of the intermediate element (8) is accommodated in a guiding manner.

4. Solar module holder according to claim 3 in combination with claim 2, **characterised in that** the outer cross-sectional contour (54) of the section (17) of the intermediate element (8) and/or of an extension (55) of the section (17) is square.

5. Solar module holder according to any of the preceding claims, **characterised in that** the intermediate element (8) has a longitudinal channel (21) in which a threaded screw (36) belonging to the screw connection (11) engages.

6. Solar module holder according to claim 5, **characterised in that** the longitudinal channel (21) is formed as a screw channel (21') for the threaded screw (36) or **in that** a nut (51) for the threaded screw (36) is inserted into the longitudinal channel (21).

7. Solar module holder according to claim 6, **characterised in that** at least one supporting projection (49, 50) for axially fixing the nut (51) is provided in the longitudinal channel (21).

8. Solar module holder according to one of claims 6 or 7, **characterised in that** the nut (51) is accommodated in the longitudinal channel (21) in a non-rotatable manner.

9. Solar module holder according to claim 3, **characterised in that** the guide walls (12, 13) of the clamping holder (9) are connected to one another by means of a transverse web (14).

10. Solar module holder according to claim 9 in combination with claim 5, **characterised in that** the threaded screw (36) passes through an opening (39) of the transverse web (14) and is supported by means of a screw head (37) on the transverse web (14) for applying a clamping force of the holding clamp (46, 47).

11. Solar module holder according to any of the preceding claims, **characterised in that** the intermediate element (8) has a slot nut (20) which is pushed into a receptacle (33) of the basic holder (7) and which, when the clamping force of the holding clamp (46, 47) is applied, is supported undisplaceably on a receiving surface (48) of the receptacle (33) of the basic holder (7).

12. Solar module holder according to claim 11, **characterised in that** the basic holder (7) has a base plate (28) on which there are provided two walls (29, 30) which run parallel to one another and extend transversely to the plane of the base plate (28) and between which the receptacle (33) is formed by means of a longitudinal projection (31, 32) formed on at least one of the walls (29, 30).

13. Solar module holder according to claim 12 in combination with claim 4, **characterised in that** the extension (55) of the section (17) of the intermediate element (8) extends in a guiding manner until between the walls (29, 30) of the basic holder (7) in the direction towards the longitudinal projection (31, 32).

14. Solar module holder according to claim 12 in combination with claim 4, **characterised in that** the slot nut (20) is connected to the extension (55) via a retaining web (19) forming a neck (18) of the intermediate element (8), the longitudinal projection (31, 32) adjoining the neck (18).

15. Solar module holder in accordance with claims 2 and 12 or 3 and 12, **characterised in that** a clamping web (15, 16) having the clamping surface (44) projects away from the at least one guide wall (12, 13) of the clamping holder (9) and **in that** a counterclamping web (34, 35) having the counterclamping surface (45) projects away from at least one of the walls (29, 30) of the basic holder (7).

16. Solar module holder according to any of the preceding claims, **characterised in that** the intermediate element (8), the clamping holder (9) and/or the basic holder (7) is/are configured as an extruded component.

17. Solar module holder according to at least one of the preceding claims 11 and/or 14, **characterised in that** the neck (18) and/or the slot nut (20) has/have a square peripheral contour.

## Revendications

1. Support de module solaire (4) pour maintenir par serrage un module solaire (1), qui présente un support de base (7) pouvant être fixé à l'emplacement de montage, un élément intermédiaire (8) et un support de serrage (9), dans lequel une surface de serrage (44) du support de serrage (9) forme une serrage de maintien (46, 47) pour le module solaire (1) avec une surface de contre-serrage (45) du support de base (7) et dans lequel l'élément intermédiaire (8) est maintenu de manière déplaçable sur le support de base (7) perpendiculairement au sens du serrage de la serrage de maintien (46, 47) et le support de serrage (9) est relié de manière opérationnelle à l'élément intermédiaire (8) au moyen d'un raccord vissé (11) ayant un axe de rotation (27), le support de serrage (9) étant guidé sur l'élément intermédiaire (8) de manière à ne pouvoir tourner par rapport à l'axe de rotation (27) du raccord vissé (11) par un dispositif anti-rotation (53), **caractérisé en ce que** l'élément intermédiaire (8) est maintenu au moyen d'un raccord pierre rainuré (10) sur le support de base (7).

2. Support de module solaire selon la revendication 1, **caractérisé en ce que** le support de serrage (9) présente au moins une paroi de guidage (12, 13) qui est guidée de manière mobile le long d'une zone du contour extérieur (54) de la section transversale de l'élément intermédiaire (8) dans la direction de l'axe de rotation (27).

3. Support de module solaire selon l'une des revendications précédentes, **caractérisé en ce que** le support de serrage (9) présente deux parois de guidage (12, 13) parallèles l'une à l'autre, entre lesquelles une section (17) de l'élément intermédiaire (8) est logée en guidage.

4. Support de module solaire selon la revendication 3 en liaison avec la revendication 2, **caractérisé en ce que** le contour extérieur (54) de la section (17) de l'élément intermédiaire (8) et/ou d'une extension (55) de la section (17) est carré.

5. Support de module solaire selon l'une des revendications précédentes, **caractérisé en ce que** l'élément intermédiaire (8) présente un canal longitudinal (21) dans lequel s'engage une vis filetée (36) appartenant au raccord vissé (11).

6. Support de module solaire selon la revendication 5, **caractérisé en ce que** le canal longitudinal (21) est réalisé sous la forme d'un canal de vis (21') pour la vis filetée (36) ou qu'un écrou (51) pour la vis filetée (36) est inséré dans le canal longitudinal (21).

7. Support de module solaire selon la revendication 6, **caractérisé en ce qu'**au moins une saillie de support (49, 50) pour la fixation axiale de l'écrou (51) est prévue dans le canal longitudinal (21).

8. Support de module solaire selon l'une des revendications 6 ou 7, **caractérisé en ce que** l'écrou (51) est logé dans le canal longitudinal (21) de manière à ne pouvoir tourner.

9. Support de module solaire selon la revendication 3, **caractérisé en ce que** les parois de guidage (12, 13) du support de serrage (9) sont reliées entre elles par une bande transversale (14).

10. Support de module solaire selon la revendication 9 en liaison avec la revendication 5, **caractérisé en ce que** la vis filetée (36) traverse une ouverture (39) de la traverse (14) et est supportée par une tête de vis (37) sur la traverse (14) pour appliquer une force de serrage du serrage de maintien (46, 47).

11. Support de module solaire selon l'une des revendications précédentes, **caractérisé en ce que** l'élément intermédiaire (8) présente un coulisseau (20) qui est poussé dans un logement (33) du support de base (7) et qui, lorsque la force de serrage du serrage de maintien (46, 47) est appliquée, est supporté de manière fixe sur une surface réceptrice (48) du logement (33) du support de base (7).

12. Support de module solaire selon la revendication 11, **caractérisé en ce que** le support de base (7) présente une plaque de base (28) sur laquelle sont prévues deux parois (29, 30) qui s'étendent parallèlement l'une à l'autre et transversalement au plan de la plaque de base (28) et entre lesquelles le logement (33) est formé par une saillie longitudinale (31, 32) formée sur au moins une des parois (29, 30).

13. Support de module solaire selon la revendication 12 en liaison avec la revendication 4, **caractérisé en ce que** l'extension (55) de la section (17) de l'élément intermédiaire (8) s'étend de manière guidée entre les parois (29, 30) du support de base (7) dans la direction de la saillie longitudinale (31, 32).

14. Support de module solaire selon la revendication 12 en liaison avec la revendication 4, **caractérisé en ce que** le coulisseau (20) est relié à l'extension (55) par l'intermédiaire d'une bande de retenue (19) formant un col (18) de l'élément intermédiaire (8), la saillie longitudinale (31, 32) étant adjacente au col (18).

15. Support de module solaire selon les revendications 2 et 12 ou 3 et 12, **caractérisé en ce qu'**une bande de serrage (15, 16) présentant la surface de serrage (44) dépasse d'au moins une paroi de guidage (12, 13) du support de serrage (9) et **en ce qu'**une barrette de contre-serrage (34, 35) présentant la surface de contre-serrage (45) dépasse d'au moins une des parois (29, 30) du support de base (7).

16. Support de module solaire selon l'une des revendications précédentes, **caractérisé en ce que** l'élément intermédiaire (8), le support de serrage (9) et/ou le support de base (7) sont réalisés sous forme de pièce extrudée.

17. Support de module solaire selon au moins l'une des revendications précédentes 11 et/ou 14, **caractérisé en ce que** le col (18) et/ou le bloc coulissant (20) présente un contour périphérique carré.
